# FASCICULE DE BREVET EUROPEEN

(11) **EP 0 321 347 B1**
(45) Date de publication et mention de la délivrance du brevet: **13.10.1993**
(21) Numéro de dépôt: 88403196.4
(22) Date de dépôt: 15.12.1988
(51) Int. Cl.: H01L 29/60, H01L 21/28, H01L 29/08

(54) **Procédé de fabrication d'un transistor MIS à extrémité d'interface diélectrique de grille/substrat relevée**
Verfahren zur Herstellung eines MIS-Transistors mit an den Endpunkten erhöhter dielektrischer Gate/Substrat-Grenzfläche
Method of manufacturing a MIS transistor with raised dielectric interface of the gate and substrate at its extremities

(30) Priorité: 18.12.1987 FR 8717725
(43) Date de publication de la demande: 21.06.1989
(73) Titulaire: COMMISSARIAT A L'ENERGIE ATOMIQUE, 75015 Paris Cédex 15 (FR)
(72) Inventeur: Jeuch, Pierre, F-38180 Seyssins (FR); Niez, Jean-Jacques, F-38100 Grenoble (FR)
(74) Mandataire: Mongrédien, André

(56) Documents cités:
- EP-A- 0 220 542
- US-A- 4 393 391
- PATENT ABSTRACTS OF JAPAN, vol. 4, no. 5 (E-165), 16 janvier 1980 ; & JP-A-54146584
- JAPANESE JOURNAL OF APPLIED PHYSICS, vol. 24, no. 6, part 2, pages L 457-459, juin 1985, Tokyo, Japan ; H. IKEDA : "Substrate Current of Submicrometer Buried-Gate MOSFET"
- IEEE TRANSACTIONS ON ELECTRON DEVICES, vol. ED-30, no. 6, juin 1983, pages 681-686, New York, US ; E. TAKEDA : "New Grooved-Gate MOSFET with Drain Separated from Channel Implanted Region (DSC)"
- JAPANESE JOURNAL OF APPLIED PHYSICS, vol. 16, supplement 16-1, 1977, pages 179-183, Tokyo, Japan ; S. NISHIMATSU et al : "Grooved-Gate MOSFET"
- PATENT ABSTRACTS OF JAPAN, vol. 10, no. 313 (E-448)(2369), 24 octobre 1986 ; & JP-A-61125175

## Description

La présente invention concerne les transistors MIS (Métal-Isolant-Semiconducteur), en particulier MOS (Métal-Oxyde-Semiconducteur), et plus précisément un procédé de fabrication d'un transistor MIS à extrémité d'interface diélectrique de grille/substrat relevée.

Elle s'applique notamment à la fabrication de transistors MOS submicroniques (dont les dimensions ne dépassent pas 1 micromètre environ) et donc à la fabrication de circuits intégrés qui relèvent de l'intégration à très grande échelle (VLSI).

L'intégration à très grande échelle de transistors MOS nécessite la réduction des dimensions de ces transistors et notamment la réduction de la longueur des canaux de tels transistors. Or, la réduction de la longueur du canal d'un transistor MOS pose notamment des problèmes de vieillissement de ce transistor. En effet, celui-ci se dégrade au cours du temps, d'autant plus vite que la longueur du canal est petite et essentiellement lorsqu'il fonctionne en régime de saturation, à cause d'électrons dans le canal, rendus très énergétiques par des champs électriques intenses engendrés dans le canal près du drain du transistor (supposé à canal N), électrons qui sont appelés "électrons chauds" et qui dégradent le transistor. En effet, ces électrons sont injectés dans le diélectrique de grille et perturbent le fonctionnement du transistor. Les champs électriques sont d'autant plus intenses que la longueur du canal est petite.

De la même manière, un transistor MOS à canal P se dégrade au cours du temps à cause de trous dans le canal (ces trous constituant dans ce cas lés porteurs minoritaires), trous rendus de la même façon très énergétiques par des champs électriques intenses présents près du drain du transistor lorsque ce dernier fonctionne en régime de saturation.

Diverses techniques ont déjà été proposées pour résoudre ces problèmes. L'une des techniques les plus utilisées est la technique dite LDD (Lightly Doped Drain selon la terminologie anglo-saxonne). Cette technique est notamment mentionnée dans l'article de S. BAMPI et al. publié dans IEDM 85, 9.2, IEEE, 1985, pages 234 à 237.

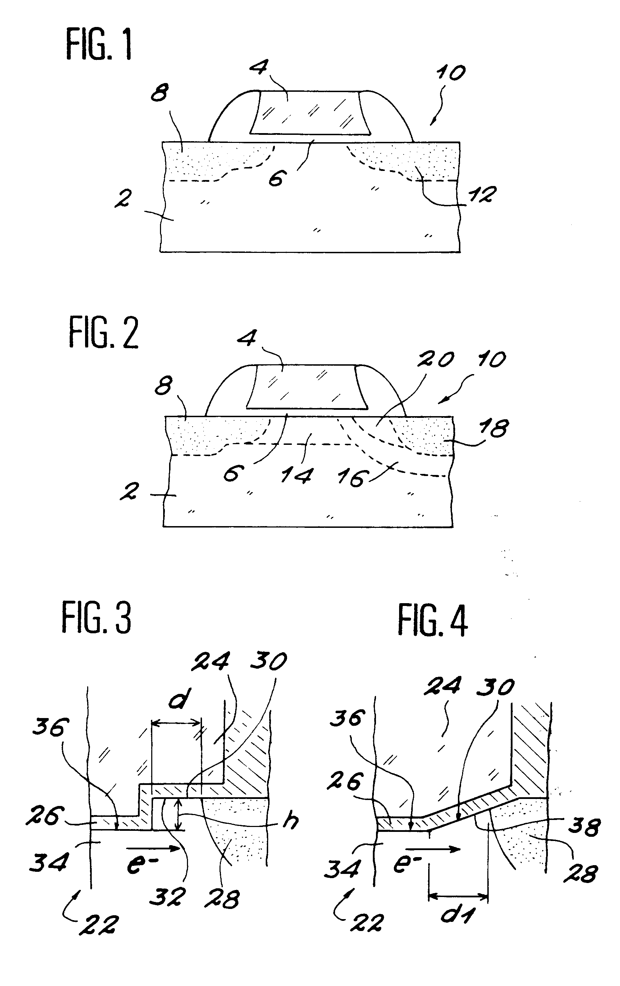

La figure 1 illustre schématiquement la technique LDD : dans un transistor MOS comportant, sur un substrat 2, une grille 4 séparée du substrat par une couche diélectrique 6 ayant une interface plane avec le substrat 2, ainsi qu'une source 8 et un drain 10 qui comportent des portions s'étendant sous ladite interface, la portion 12 correspondant au drain 10 n'est que légèrement dopée, par rapport au reste du drain.

Cette technique LDD diminue la valeur maximale du champ électrique près du drain. Cependant, elle introduit une résistance électrique en série avec le canal du transistor, ce qui nuit aux performances de ce dernier.

D'autres techniques connues, éventuellement combinées à la technique LDD, permettent de faire passer le courant d'électrons (en supposant le transistor MOS à canal N) en profondeur près du drain, de façon que les "électrons chauds" soient engendrés loin de l'interface substrat/diélectrique où ils peuvent être piégés. Une augmentation de 10 nanomètres de la profondeur du courant électronique permet de dégrader dix fois moins vite le diélectrique.

Un exemple de ces autres techniques est également mentionné dans l'article cité plus haut et schématiquement illustré sur la figure 2. Dans le transistor MOS représenté sur cette figure, le substrat 2 est par exemple de type P⁻ et, sous l'interface plane diélectrique/substrat se trouve une zone 14 de type P reliant la source 8 au drain 10. Sous ladite interface, ce drain 10 comprend, à partir de la zone 14, une portion de type N⁻ référencée 16 ainsi qu'une portion de type N⁺ référencée 18 et entre ces portions 16 et 18, un domaine de type P⁺ référencé 20.

Cependant, le transistor MOS schématiquement représenté sur la figure 2 présente un inconvénient : il est difficile de réduire sa taille (en conservant bien entendu ses proportions), car, en particulier, il est difficile de réaliser un domaine 20 de petites dimensions.

La présente invention a justement pour objet un procédé de fabrication d'un transistor MIS, en particulier MOS, dans lequel le courant de porteurs minoritaires est éloigné de l'interface diélectrique de grille/substrat, près du drain, en régime de saturation (c'est en effet en régime de saturation que l'on observe des champs électriques intenses et la génération de "porteurs minoritaires chauds" au voisinage du drain), dont il est possible de réduire les dimensions, et qui ne présente pas de résistance en série avec le canal dudit transistor.

Contrairement à certaines techniques connues, dans un transistor obtenu conformément à la présente invention, le courant de porteurs minoritaires n'est pas dévié loin de l'interface diélectrique de grille/substrat par des profils de dopage spéciaux (voir description de la figure 2) mais ladite interface a une forme géométrique qui évite justement d'avoir un courant de surface près du drain.

La présente invention permet en effet d'obtenir un transistor MIS comprenant :
- un substrat semiconducteur ayant un type de dopage donné,
- sur ce substrat, un élément électriquement conducteur destiné à constituer la grille du transistor, cette grille étant électriquement isolée du substrat par une couche diélectrique qui présente ainsi une interface avec le substrat, et
- dans le substrat, de part et d'autre de la grille, deux zones destinées à constituer respectivement le drain et la source du transistor et ayant un type de dopage opposé à celui du substrat, ces zones comportant respectivement des portions qui s'étendent sous ladite interface, cette dernière comportant ainsi deux extrémités qui longent le substrat pour s'étendre ensuite au-dessus de ces portions, les extrémités de l'interface étant relevées par rapport ou reste de cette interface.

Dans un transistor MOS, en régime ohmique (le potentiel Vd appliqué au drain étant faible en voleur absolue), le courant de porteurs minoritaires est un courant de surface dans la couche d'inversion du transistor en fonctionnement. En régime de saturation, cette couche d'inversion disparaît près du drain. Les porteurs minoritaires (des électrons dans le cas d'un substrat de type P) sont alors accélérés par le champ électrique existant au voisinage du drain mais ne sont plus commandés par la grille.

Dans un transistor obtenu conformément à l'invention, l'extrémité de l'interface diélectrique/substrat, extrémité située du côté du drain, est plus haute que le reste de ladite interface et les porteurs minoritaires poursuivent en régime de saturation leur déplacement en direction du drain, en suivant le champ électrique, indépendamment de la proximité de la grille. Ces porteurs minoritaires rencontrent donc la zone du drain, au voisinage de laquelle existe un maximum de champ électrique, en étant éloignés de ladite interface.

Le courant de porteurs minoritaires dans la couche d'inversion suit cette interface -même si celle-ci n'est pas plane- du côté de la source, quel que soit le régime, et du côté du drain, uniquement en régime ohmique.

La structure du transistor obtenu conformément à l'invention n'introduit donc aucune résistance électrique en série avec le canal du côté de la source (ou encore du côté du drain, pour un potentiet Vd appliqué au drain, faible en valeur absolue), contrairement aux techniques de type LDD.

Le transistor peut avoir une structure symétrique, les zones correspondant à la source et au drain étant identiques et donc interchangeables, ce qui peut être très important pour faciliter la fabrication d'un tel transistor et surtout les connexions dans les circuits intégrés utilisant plusieurs exemplaires de ce transistor.

On conçoit que le procédé objet de l'invention se prête particulièrement bien à la fabrication d'un transistor de faible taille, car une différence de hauteur de quelques dizaines de nanomètres entre les extrémités de l'interface et le reste de cette interface est suffisante. De ce fait, l'invention peut s'appliquer à la fabrication de transistors de dimensions inférieures à 0,5 micromètre. Toutes les techniques connues utilisant des variations de profil de dopage sont bien plus limitées du point de vue de la réduction de taille car les gradients de dopage réalisables sont limités.

La présente invention permet de réaliser un transistor MIS dans lequel chaque extrémité relevée est en forme de marche, ou un transistor MIS dans lequel chaque extrémité relevée est en forme de rampe.

On connaît déjà par Jap. Jnl. Appl. Phys. vol. 16, supp. 16-1, 1977 p. 179-183, un procédé de fabrication d'un MOSFET à grille enterrée. On connaît aussi par Jap. Jnl. Appl. Phys. vol. 24 n^{o} 6 pt. 2, p. L 457-459, juin 1985 un MOSFET à grille enterrée. On connaît également par Pat. Abstract of Japan vol. 4 n^{o} 5 (E-165), 16 janvier 1980 et JP-A-54 146 584 un procédé de fabrication d'un transistor MOSFET.

De façon précise, la présente invention concerne un procédé de fabrication d'un transistor MIS conformément à la revendication 1.

La présente invention sera mieux comprise à la lecture de la description qui suit, d'exemples de réalisation donnés à titre purement indicatif et nullement limitatif, en référence aux dessins annexés sur lesquels :
- les figures 1 et 2 sont des vues schématiques de transistors MOS connus et ont déjà été décrites,
- la figure 3 est une vue schématique et partielle d'un premier transistor réalisable par un procédé conforme à l'invention,
- la figure 4 est une vue schématique et partielle d'un second transistor réalisable par un autre procédé conforme à l'invention,
- les figures 5A à 5I illustrent schématiquement différentes étapes d'un procédé conforme à l'invention, permettant la fabrication d'un transistor du genre de celui qui est représenté sur la figure 3, et
- les figures 6A à 6K illustrent schématiquement différentes étapes d'un autre procédé conforme à l'invention, permettant la fabrication d'un transistor du genre de celui qui est représenté sur la figure 4.

Sur la figure 3, on a représenté schématiquement et partiellement un premier transistor MIS qui est réalisable par un procédé conforme à l'invention. Ce transistor comprend : un substrat 22 par exemple en silicium monocristallin de type P, une grille 24 par exemple en silicium polycristallin convenablement dopé pour être électriquement conducteur, cette grille 24 étant placée au-dessus du substrat, une couche diélectrique 26 par exemple en silice, s'étendant entre la grille et le substrat, ainsi qu'une zone 28 de type N⁺ dans l'exemple donné, destinée à constituer le drain du transistor.

Une partie de la zone 28 est située sous l'interface existant entre la couche diélectrique 26 et le substrat 22 et cette interface comporte ainsi une extrémité 30 qui longe le substrat pour s'étendre ensuite au-dessus de la partie de la zone 28. Cette extrémité forme une marche 32 ascendante. Il en est donc de même pour la couche 26 à cet endroit. La zone de drain 28 s'étend ainsi plus haut que la zone 34 correspondant au canal du transistor.

A titre purement indicatif et nullement limitatif, la hauteur de marche h est de l'ordre de 50 nm à 100 nm, la zone de drain 28 s'étend dans le substrat jusqu'à une profondeur de l'ordre de 200 nm à 300 nm, et la distance minimale d entre la zone 28 de drain et la partie de marche perpendiculaire au reste 36 de l'interface est de l'ordre de 100 nm à 200 nm.

Une autre zone, correspondant à la source du transistor, de type N⁺ dans cet exemple, n'est pas représentée sur la figure 3. Cette autre zone située à l'opposé de la zone 28 par rapport à la zone de canal 34, est en partie située sous ladite interface.

Lorsque le transistor fonctionne en régime de saturation, les électrons traversent le canal en direction de la zone de drain, parallèlement à l'interface (dans le cas présent, parallèlement au reste sensiblement plan 36 de l'interface) puis poursuivent leur trajet en ligne droite suivant le champ électrique, en étant éloignés de l'interface, lorsqu'ils sont au voisinage de la zone de drain où le champ électrique est maximal.

Sur la figure 4, on a représenté schématiquement et partiellement un second transistor MIS qui est réalisable par un autre procédé conforme à l'invention et qui diffère simplement du premier transistor décrit en référence à la figure 3 par le fait que la marche 32 (ascendante) est remplacée par une rampe 38 (montante), qui rend encore la portion de la zone de drain située sous ladite extrémité d'interface 30 plus haute que la zone correspondant au canal du transistor, les électrons étant ainsi encore éloignés de l'interface, dans ladite extrémité, lorsqu'ils sont au voisinage du drain.

A titre purement indicatif et nullement limitatif, la rampe a une pente de l'ordre de 30° à 45°, la zone de drain 28 s'étend dans le substrat jusqu'à une profondeur de l'ordre de 200 nm à 300 nm, et la distance minimale d1 entre la zone 28 de drain et le début de la rampe est de l'ordre de 150 nm à 300 nm.

Le transistor de la figure 3 ou de la figure 4 pourrait avoir une structure symétrique par rapport au plan perpendiculaire au plan des dessins et médiateur de la zone de canal 34.

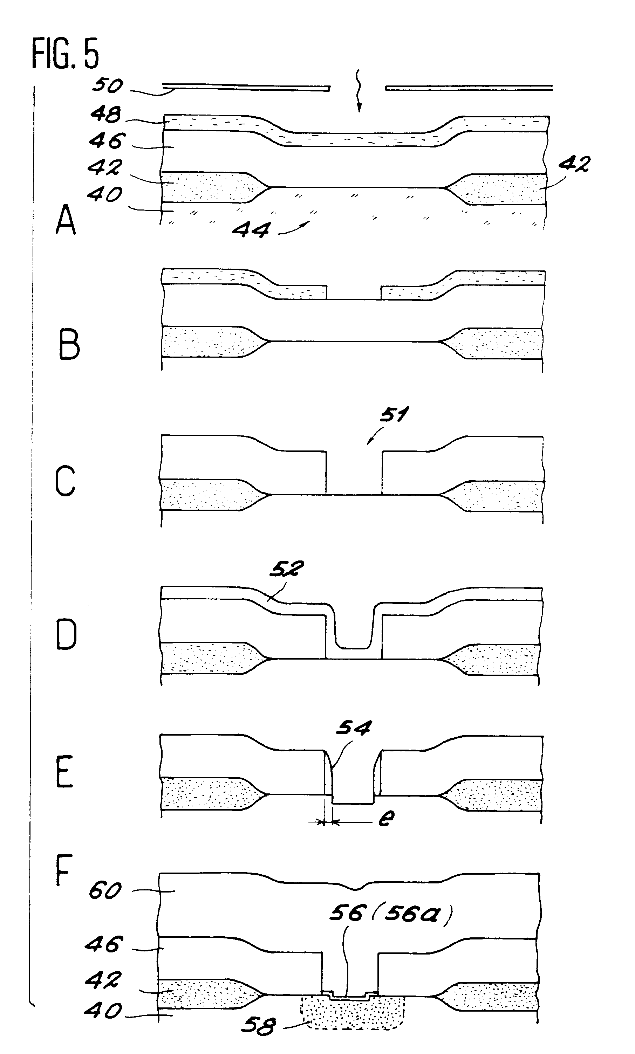

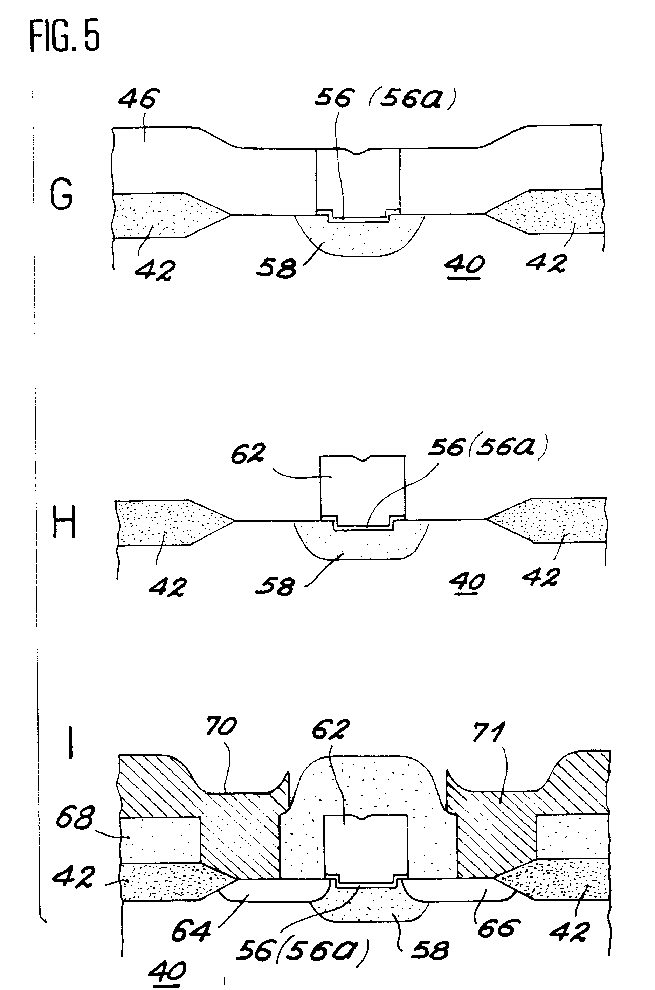

Sur les figures 5A à 5I, on a représenté schématiquement différentes étapes d'un procédé conforme à l'invention, permettant la fabrication d'un transistor MOS qui est du genre du transistor décrit en référence à la figure 3 et qui a ladite structure symétrique.

On part d'un substrat 40 par exemple en silicium monocristallin de type P avec une concentration de l'ordre de 10¹⁶ atomes par cm³ par exemple (figure 5A). On réalise de façon classique sur ce substrat 40, un oxyde de champ SiO₂ référencé 42, autour d'une zone 44 de la surface du substrat, zone qui est appelée "zone active" et dans laquelle on souhaite créer le transistor. On forme ensuite sur le substrat une couche 46 ''sacrificielle" de silice d'environ 500 nanomètres d'épaisseur par exemple, par une technique de dépôt chimique en phase vapeur à basse pression (LPCVD) par exemple.

On élimine ensuite un morceau de la couche 46, où l'on souhaite réaliser la grille du transistor, ce morceau s'étendant au-dessus d'une portion de la zone active et également au dessus d'une partie de l'oxyde de champ 42, perpendiculairement à la figure 5A et de part et d'autre de ladite portion vue de dessus, car la grille à réaliser s'étend non seulement au-dessus de ladite portion mais encore au-dessus d'une partie de l'oxyde de champ, perpendiculairement à la figure 5A et de part et d'autre de ladite portion vue de dessus (voir plus loin).

Pour l'élimination dudit morceau, on peut procéder de la façon suivante : on dépose à la surface de la couche 46 une couche 48 de résine photosensible positive de 1,4 micromètre d'épaisseur par exemple. On irradie cette résine par une lumière appropriée à travers un masque 50 comportant une ouverture prévue pour délimiter ladite grille (cette ouverture se présentant par exemple sous la forme d'un rectangle qui est au-dessus de la zone active et qui déborde sur l'oxyde de champ dans un plan perpendiculaire à la figure 5A, rectangle dont la largeur, visible sur cette figure, est par exemple de l'ordre de 0,8 micromètre - les valeurs d'énergie et de doses des implantations ioniques indiquées dans la suite du procédé étant données pour cette largeur de grille). On élimine ensuite la partie irradiée de la résine (figure 5B). On enlève alors la portion de la couche 46 limitée par la résine restante, par exemple par gravure ionique réactive au moyen de CHF₃ (figure 5C), ce qui crée un trou 51 ayant deux flancs opposés verticaux et ayant en outre pour fond ladite portion de zone active. La couche de résine 48 restante est alors éliminée par une attaque chimique ou par un plasma d'oxygène.

On dépose ensuite sur toute la surface du substrat résultant de ce qui précède, une couche 52 de Si₃N₄ dont l'épaisseur est de 200 nanomètres par exemple, par dépôt chimique en phase vapeur à basse pression (figure 5D).

On effectue alors une gravure anisotrope de cette couche 52 par exemple par gravure ionique réactive au moyen de SF₆, de sorte que les flancs verticaux du trou 51 restent recouverts d'une épaisseur 54 de Si₃N₄ épaisseur e qui peut être de l'ordre de 200 nm.

On effectue ensuite une gravure du silicium du substrat délimité par l'épaisseur 54, sur une profondeur de 50 nanomètres par exemple (figure 5E). Cette attaque est réalisée sélectivement par rapport à la couche 46 et à l'oxyde de champ 42 par exemple en prolongeant la gravure ionique réactive précédente, effectuée au moyen de SF₆.

On élimine alors l'épaisseur 54 de Si₃N₄ restante au moyen d'acide phosphorique par exemple. On réalise ensuite (figure 5F) l'oxydation du substrat à l'endroit de la gravure pour obtenir une couche 56 de silice de 20 nanomètres d'épaisseur par exemple, après quoi on effectue de façon avantageuse un dopage de type P par implantation ionique de BF₂ classique (à travers la couche 56) de la zone 58 correspondant au canal du transistor, l'énergie de l'implantation étant de 50 keV, la dose étant de l'ordre de 10¹² atomes par cm². On dépose ensuite sur tout le substrat une couche 60 de silicium polycristallin dont l'épaisseur est par exemple de 800 nanomètres puis on réalise un dopage de type N⁺ de cette couche 60, de façon classique, au moyen de POCl₃, pour rendre ce silicium polycristallin électriquement conducteur.

Selon une variante avantageuse, après l'implantation de la zone 58, destinée à doper le canal du transistor, et avant le dépôt de la couche 60 de silicium polycristallin, on élimine la couche de silice 56 (par voie chimique, au moyen de HF dilué) puis on oxyde à nouveau le substrat 40, pour former l'oxyde de grille, d'où une couche de silice 56a de 20 nm d'épaisseur par exemple.

Après dopage de la couche 60, on effectue une gravure "pleine plaque" de la couche 60, par gravure ionique réactive au moyen SF₆, en arrêtant cette gravure lorsque la couche 46 de silice est mise à nue, d'où l'obtention de la grille 62 du transistor (figure 5G).

On élimine alors cette couche 46 de silice par exemple par gravure ionique réactive au moyen de CHF₃ (figure 5H).

La fabrication du transistor est ensuite achevée de façon classique (figure 5I) : on réalise, par exemple par implantation ionique dans le substrat délimité par l'oxyde de champ et la grille 62, un dopage de type N de zones 64 et 66 du substrat destinées à constituer respectivement la source et le drain du transistor, chaque zone 64 ou 66 s'étendant sur une profondeur de 250 nm par exemple et le dopage étant réalisé par implantation ionique d'arsenic à 100 keV, avec une dose de 5x10¹⁵ atomes par cm² par exemple. Après cela, on effectue un recuit à 850°C pendant 30 minutes pour activer les dopants implantés.

On dépose ensuite, sur tout le substrat, une couche 68 d'un isolant tel que la silice, par exemple par dépôt chimique en phase vapeur à basse pression, de 600 nanomètres d'épaisseur par exemple. On grave alors cette couche 68 en vue de réaliser les contacts de grille, de source et de drain, et l'on réalise effectivement ces contacts 70, 71 par métallisation. Le contact de grille n'étant pas dans le même plan que les contacts de source et de drain, n'est pas représenté sur la figure 5I.

Le transistor ainsi obtenu a une structure symétrique. Pour obtenir un transistor à structure dissymétrique (interface diélectrique de grille/substrat ne présentant qu'une marche du côté du drain du transistor), il suffirait, par exemple, après avoir obtenu l'épaisseur 54 de Si₃N₄ sur les deux flancs verticaux du trou 51, d'éliminer cette épaisseur 54 sur l'un de ces flancs, par gravure à travers un masque approprié, afin de ne conserver cette épaisseur 54 que sur l'autre de ces flancs verticaux. On effectuerait ensuite la gravure du silicium du substrat comme indiqué plus haut.

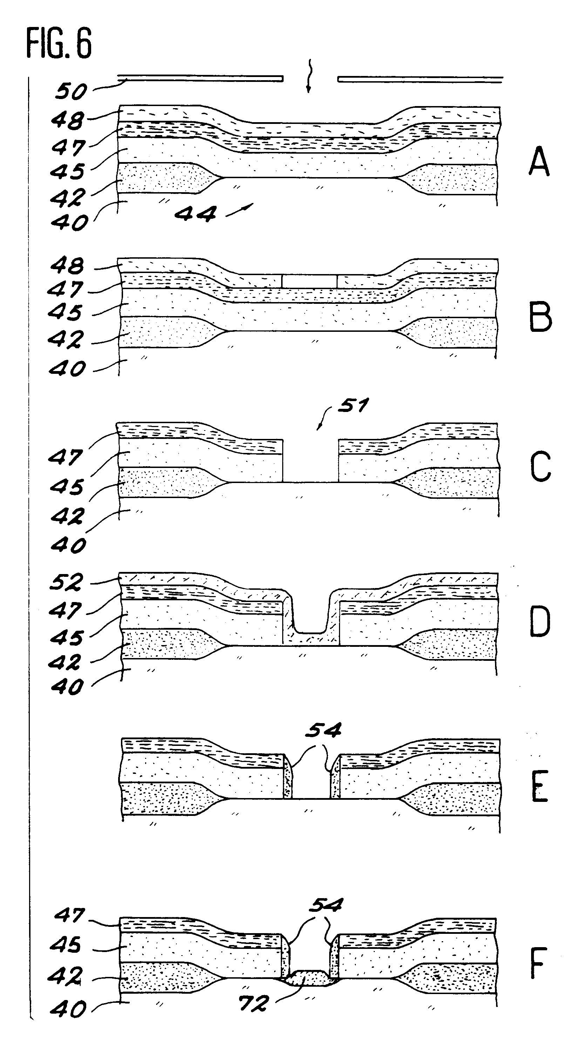

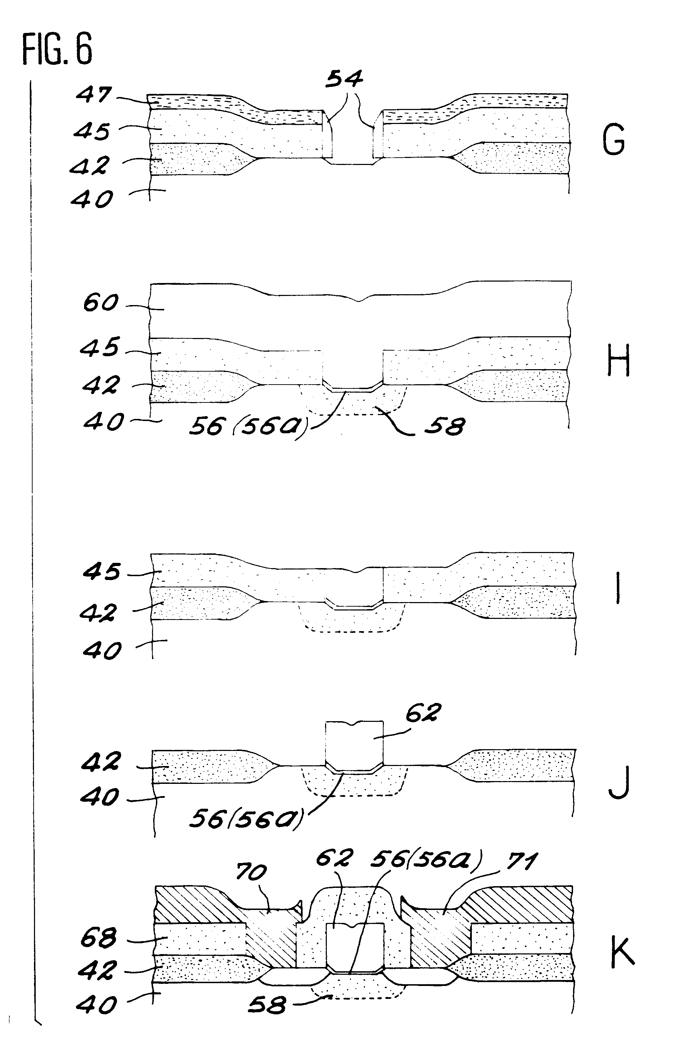

Les figures 6A à 6K illustrent schématiquement différentes étapes d'un autre procédé conforme à l'invention, permettant de fabriquer un transistor MOS qui est du genre du transistor décrit en référence à la figure 4 et qui a ladite structure symétrique.

Au départ, on procède comme on l'a expliqué en référence à la figure 5A : on réalise l'oxyde de champ 42 sur le substrat 40 puis, au lieu de réaliser la couche 46, on réalise une double couche 45-47, à savoir une couche "sacrificielle" 45 de silice de 300 nanomètres d'épaisseur par exemple, déposée sur l'oxyde de champ et sur la zone 44, cette couche 45 étant surmontée d'une couche "sacrificielle" 47 de Si₃N₄ de 200 nanomètres d'épaisseur par exemple, obtenue par dépôt chimique en phase vapeur à basse pression. La couche de résine 48 est ensuite déposée sur la couche 47 (figure 6A) puis insolée à travers le masque 50 et la résine insolée est éliminée. Le trou 51 est alors formé à travers la double couche 45-47 (figures 6B et 6C). A cet effet, les couches 47 et 45 sont successivement gravées par gravure ionique réactive au moyen CHF₃ par exemple, au-dessus de ladite portion de la zone active et également au-dessus de l'oxyde de champ 42, perpendiculairement à la figure 6A, comme on l'a vu plus haut à propos de la figure 5A. La couche 48 restante est éliminée de la même façon que précédemment.

La couche 52 de Si₃N₄ est ensuite déposée (figure 6D). On élimine alors la couche 52 de Si₃N₄ par une gravure anisotrope, par exemple une gravure ionique réactive au moyen de CHF₃, en s'arrêtant lors de l'atteinte de la couche 47, l'anisotropie de la gravure laissant ainsi subsister sur les flancs verticaux du trou 51 une épaisseur de Si₃N₄ analogue à l'épaisseur 54 de la figure 5E et portant ainsi la même référence (figure 6E).

On effectue ensuite une oxydation thermique du substrat présent au fond du trou 51, pour obtenir une couche de silice 72 de 150 nanomètres d'épaisseur par exemple (figure 6F). Cette couche de silice 72 est ensuite enlevée au moyen d'acide fluorhydrique par exemple, le fond du trou ayant ainsi des bords en pente permettant d'aboutir à l'interface diélectrique de grille/substrat souhaitée pour le transistor (figure 6G).

On enlève ensuite le reste de la couche 47 et l'épaisseur 54 de Si₃N₄ par exemple au moyen d'acide phosphorique, après quoi la couche 56 est formée, le dopage de la zone 58 est réalisé puis la couche 56 est avantageusement éliminée et remplacée par la couche de silice 56a, puis la couche 60 est réalisée (figure 6H), tout ceci ayant déjà été décrit en référence à la figure 5F pour le transistor correspondant à cette dernière.

Ensuite, le transistor est achevé (figures 6I à 6K) comme on l'a déjà expliqué en référence aux figures 5G à 5I, pour le transistor correspondant à ces dernières.

On notera que les exemples de procédé, décrits en référence aux figures 5A-5I, 6A-6K et 7A-7I, conduisent chacun avantageusement à un transistor dont la structure est symétrique, la zone 64 (respectivement 66) pouvant correspondre à la source (respectivement au drain) du transistor, ou au drain (respectivement à la source) de ce transistor.

Par ailleurs, ces exemples de procédé ont été donnés en utilisant un substrat semiconducteur de type P mais bien entendu l'homme du métier pourrait adapter ces exemples à la fabrication d'un transistor MIS conforme à l'invention sur un substrat de type N.

## Revendications

1. Procédé de fabrication d'un transistor MIS, caractérisé en ce qu'il comprend les étapes successives suivantes :
- on forme à la surface d'un substrat semiconducteur (40) ayant un type de dopage donné, une première couche (42) électriquement isolante, cette couche entourant une zone (44) de la surface du substrat,
- on forme sur la première couche isolante et sur ladite zone, une deuxième couche (46; 45, 47),
- on fait apparaître une partie de ladite zone en éliminant un morceau de la deuxième couche (46; 45, 47), ce morceau s'étendant au-dessus de cette partie, qui constitue ainsi le fond d'un trou (51) réalisé dans la deuxième couche, et au-dessus d'une partie de la première couche isolante.
- on forme une couche de protection (52) sur le substrat (40) muni dudit trou (51),
- on élimine cette couche de protection (52) sauf sur les flancs dudit trou,
- on forme dans l'épaisseur du substrat, au fond dudit trou, un creux comportant des extrémités relevées, situées sous la couche de protection des flancs du trou,
- on élimine le reste (54) de la couche de protection,
- on forme une troisième couche (56, 56a) électriquement isolante à la surface de ladite partie de ladite zone,
- on forme sur le substrat ainsi traité une couche (60) électriquement conductrice,
- on élimine cette dernière sauf dans une zone correspondant audit morceau, de façon à obtenir la grille (62) du transistor,
- on élimine le reste de la deuxième couche, et
- on forme, de part et d'autre de la grille, les zones de source (64) et de drain (66) du transistor de façon que ces zones de source et de drain comportent respectivement des portions qui s'étendent sous l'interface que la troisième couche présente avec le substrat et que cette interface comporte ainsi deux extrémités relevées correspondant auxdites extrémités relevées du creux, et qui longent le substrat pour s'étendre ensuite au-dessus de ces portions, les zones de source et de drain ayant un type de dopage opposé à celui du substrat.

2. Procédé selon la revendication 1, caractérisé en ce que l'étape de formation du creux consiste à graver anisotropiquement le substrat 140, de façon à ce que le creux présente des parois verticales.

3. Procédé selon la revendication 1, caractérisé en ce que l'étape de formation du creux consiste à oxyder le substrat du fond du trou et à éliminer la partie ainsi oxydée du substrat de façon à ce que les extrémités du creux soient inclinées par rapport au fond de celui-ci.

4. Procéde selon l'une quelconque des revendications 1 à 3, caractérisé en ce que la deuxième couche est une double couche comportant une sous-couche (45) surmontée d'une couche de protection (47), cette couche de protection étant éliminée avec le reste de la couche de protection située sur les flancs du trou, après réalisation du creux dans le substrat.

## Claims

1. Process for the production of a MIS transistor, characterized in that it comprises the following successive stages:
on the surface of a semiconductor substrate (40) having a given doping type is formed a first electrically insulating layer (42), which surrounds a zone (44) of the surface of the substrate,
on the first insulating layer and on said zone is formed a second layer (46;45,47),
part of said zone is made to appear by eliminating a fragment of the second layer (46;45,47), said fragment extending above said part, which thus constitutes the bottom of a hole (51) made in the second layer, and above a part of the first insulating layer,
a protective layer (52) is formed on the substrate (40) provided with the said hole (51),
said protective layer (52) is eliminated except on the sides of said hole,
in the thickness of the substrate, at the bottom of said hole, is formed a cavity having raised ends located beneath the protective layer of the sides of the hole,
the remainder of the protective layer is removed,
a third electrically insulating layer (56,56a) is formed on the surface of said part of said zone,
on the thus treated substrate is formed an electrically conductive layer (60),
the latter is eliminated, except in a zone corresponding to said fragment, so as to obtain the transistor gate (62),
the remainder of the second layer is eliminated and
on either side of the gate are formed source (64) and drain (66) zones of the transistor in such a way that said source and drain zones respectively have portions extending beneath the interface of the third layer with the substrate and said interface consequently has two raised ends corresponding to the raised ends of the cavity and which pass along the substrate in order to then extend above said portions, the source and drain zones having a doping type opposite to that of the substrate.

2. Process according to claim 1, characterized in that the formation stage of the cavity consists of anisotropically etching the substrate (40), so that the hollow has vertical walls.

3. Process according to claim 1, characterized in that the formation stage of the hollow consists of oxidizing the substrate of the bottom of the hole and eliminating the thus oxidized part of the substrate, so that the ends of the cavity are inclined with respect to the bottom thereof.

4. Process according to any one of the claims 1 to 3, characterized in that the second layer is a double layer having an under-layer (45) surmounted by a protective layer (47), said protective layer being eliminated with the remainder of the protective layer positioned on the sides of the hole, following the formation of the cavity in the substrate.

## Patentansprüche

1. Verfahren zur Herstellung eines MIS Transistors, dadurch gekennzeichnet, daß es folgende aufeinanderfolgende Stufen umfaßt:
- man formt auf der Oberfläche einer halbleitenden Unterlage (40) mit gegebener Dotierung, eine erste isolierende Schicht (42), diese Schicht umgibt eine Zone (44) der Oberfläche der Unterlage,
- man formt auf der ersten isolierenden Schicht und auf besagter Zone, eine zweite Schicht (46; 45, 47),
- man läßt einen Teil besagter Zone hervortreten, durch Entfernen eines Stückes der der zweiten Schicht (46; 45, 47), dieses Stück erstreckt sich oberhalb dieses Teils, welches auf diese Weise den Boden eines in der zweiten Schicht realisierten Loches (51) bildet, und oberhalb eines Teils der ersten isolierenden Schicht,
- man formt eine Schutzschicht (52) auf der Unterlage (40) versehen mit besagtem Loch (51),
- man entfernt diese Schutzschicht (52), außer auf den Flanken besagten Loches,
- man formt in Stärke der Unterlage, am Boden besagten Loches, eine Höhlung mit hochgezogenen Enden welche unter der Schutzschicht der Flanken des Loches liegen,
- man entfernt den Rest der Schutzschicht,
- man formt eine elektrisch isolierende dritte Schicht (56, 56a) an der Oberfläche besagten Teils besagter Zone,
- man formt auf der so behandelten Unterlage eine elektrisch leitende Schicht (60),
- man entfernt letztere, außer in einer Zone welche besagtem Stück entspricht, um somit das Gate (62) des Transistors zu erhalten,
- man entfernt den Rest der zweiten Schicht, und
- man formt, beidseitig vom Gate, die Zonen Source (64) und Drain (66) des Transistors derart, daß diese Zonen Source und Drain jeweils Bereiche enthalten die sich unter das aus der dritten Schicht und der Unterlage gebildete Interface erstrecken, wobei dieses Interface zwei Enden umfaßt, entsprechend besagter hochgezogener Enden der Höhlung, welche sich längs der Unterlage erstrecken und sich anschließend über diese Bereiche ausbreiten, wobei die Zonen von Source und Drain mit einer Dotierung versehen sind entgegengesetzt zu der der Unterlage.

2. Verfahren nach Anspruch 1, dadurch gekennzeichnet, daß die Stufe zur Formung der Höhlung darin besteht, die Unterlage (40) so zu gravieren, daß die Höhlung vertikale Flanken zeigt.

3. Verfahren nach Anspruch 1, dadurch gekennzeichnet, daß die Stufe zur Formung der Höhlung darin besteht, die Unterlage am Boden des Loches zu oxydieren und den auf diese Weise oxydierten Teil so zu entfernen, daß die Enden der Höhlung im Verhältnis zum Boden derselben geneigt sind.

4. Verfahren nach irgend einem der Ansprüche 1 bis 3, dadurch gekennzeichnet, daß die zweite Schicht eine doppelte Schicht ist bestehend aus einer Unterschicht (45) überlagert von einer Schutzschicht (47), wobei diese Schutzschicht mit dem Rest der Schutzschicht der Lochflanken nach Realisierung der Höhlung in der Unterlage, entfernt wird.
